# EUROPEAN PATENT APPLICATION

(11) **EP 2 645 422 A1**
(43) Date of publication of application: **02.10.2013**
(21) Application number: 11843239.2
(22) Date of filing: 18.11.2011
(51) Int. Cl.: H01L 31/04

(54) **PHOTOELECTRIC CONVERSION DEVICE**

(30) Priority: 22.11.2010 JP 2010259907
(71) Applicant: Kyocera Corporation, Kyoto-shi Kyoto 612-8501 (JP)
(72) Inventor: USHIO, SHINNOSUKE, Fushimi-ku, Kyoto-shi Kyoto612-8501 (JP)
(74) Representative: Witte, Weller & Partner
(86) International application number: PCT/JP2011/076634
(87) International publication number: WO 2012/070481

(57) **Abstract**

[Problem] The present invention aims to improve the conversion efficiency in a photoelectric conversion device.

[Solution] A photoelectric conversion device 21 comprises an electrode 2, a first semiconductor layer 31 containing a Group I-III-VI compound semiconductor and formed on the electrode 2, and a second semiconductor layer 32 having a conductivity type different from that of the first semiconductor layer 31 and formed on the first semiconductor layer 31, wherein, in the first semiconductor layer 31, a ratio C_{VI}/C_{I} of the content C_{VI} of a Group VI-B element to the content C_{I} of a Group I-B element in a surface part 31a of the second semiconductor layer 32 side thereof is larger than the ratio C_{VI}/C_{I} in a rest part 31b of the electrode 2 side thereof.

## Description

### Technical Field

The present invention relates to a photoelectric conversion device including a Group I-III-VI compound semiconductor.

### Background Art

There are photoelectric conversion devices provided with a light absorption layer formed from a chalcopyrite type Group I-III-VI compound semiconductor such as CIS or CIGS as photoelectric conversion devices used for solar power generation and the like. Such a photoelectric conversion device is described in, for example, Japanese Patent Application Laid-Open No. 6-37342 (1994). Group I-III-VI compound semiconductors each have a high light absorption coefficient and are suitable for the development of thinner and larger area photoelectric conversion devices and for reduction in production cost. Therefore, studies and developments of next generation solar cells using Group I-III-VI compound semiconductors are now underway.

A photoelectric conversion device including such a Group I-III-VI compound semiconductor comprises a structure in which two or more photoelectric conversion cells are planarly arranged. Each photoelectric conversion cell is constituted by laminating a lower electrode such as a metal electrode, a photoelectric conversion layer comprised of a semiconductor layer including a light absorption layer, a buffer layer and the like, and an upper electrode such as a transparent electrode and a metal electrode in this order on a substrate such as glass. Also, the plural photoelectric conversion cells are electrically connected in series since they are arranged such that an upper electrode of a photoelectric conversion cell is electrically connected with a lower electrode of a photoelectric conversion cell adjacent to the above photoelectric conversion cell by a connecting conductor.

Then, as the above light absorption layer, one in which the molar ratio between a Group I-B element, a Group III-B element, and a Group IV-B element is 1 : 1 : 2 is used.

### Summary of the Invention

It is always demanded of a photoelectric conversion device including a Group I-III-VI compound semiconductor to be improved in conversion efficiency. This conversion efficiency shows the rate at which the energy of sun light is converted into electric energy in a photoelectric conversion device, and is derived by, for example, dividing the value of the electric energy output from the photoelectric conversion device by the value of the energy of sunlight incident on the photoelectric conversion device and multiplying the obtained value by 100.

The present invention has been made in view of the above problem and it is an object of the present invention to improve the conversion efficiency of a photoelectric conversion device.

A photoelectric conversion device according to an embodiment of the present invention is provided with an electrode, a first semiconductor layer containing a Group I-III-VI compound semiconductor and formed on the electrode, and a second semiconductor layer having a conductivity type different from that of the first semiconductor layer and formed on the first semiconductor layer. Then, in the first semiconductor layer, a ratio C_{VI}/C_{I} of the content C_{VI} of a Group VI-B element to the content C_{I} of a Group I-B element in a surface part of the second semiconductor layer side thereof is larger than the ratio C_{VI}/C_{I} in a rest part thereof.

The photoelectric conversion device according to the embodiment enables provision of a photoelectric conversion device having a high photoelectric conversion efficiency.

### Brief Description of Drawings

Fig. 1 is a schematic view showing a state of a photoelectric conversion device according to an embodiment as viewed from above.
Fig. 2 is a schematic view showing a section of the photoelectric conversion device along the sectional line II-II in Fig. 1.
Fig. 3 is a schematic view showing a surface part and a rest part in a first semiconductor layer.
Fig. 4 is a sectional view schematically showing a state of a photoelectric conversion device during the course of production.
Fig. 5 is a sectional view schematically showing a state of a photoelectric conversion device during the course of production.
Fig. 6 is a sectional view schematically showing a state of a photoelectric conversion device during the course of production.
Fig. 7 is a sectional view schematically showing a state of a photoelectric conversion device during the course of production.
Fig. 8 is a sectional view schematically showing a state of a photoelectric conversion device during the course of production.
Fig. 9 is a sectional view schematically showing a state of a photoelectric conversion device during the course of production.
Fig. 10 is a graph showing the photoelectric conversion efficiency of a photoelectric conversion device according to an example.

### Embodiment for Carrying Out the Invention

An embodiment of the present invention will be explained with reference to the drawings. In the drawings, parts comprising the same structures and having functions are designated by the same reference signs and duplicated explanations are omitted in the following explanations. Also, these drawings are schematically shown and the size, positional relationship and the like of each structure in each drawing are not exactly illustrated.

### <(1) Structure of a photoelectric conversion device>

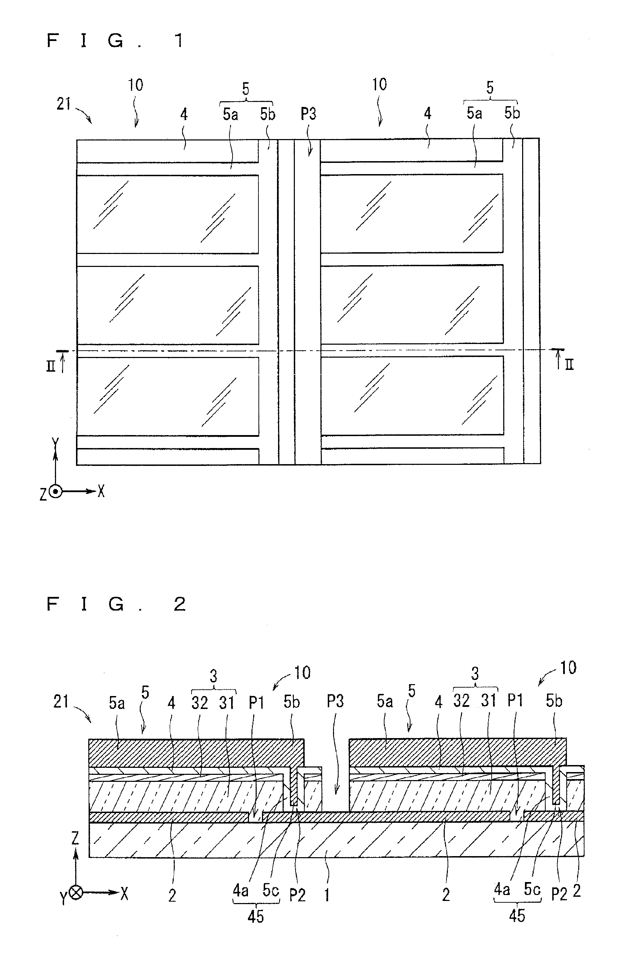

Fig. 1 is top view showing a structure of a photoelectric conversion device 21. Fig. 2 is a sectional view of the photoelectric conversion device 21 along the sectional line II-II in Fig. 1, that is, an XZ sectional view of the photoelectric conversion device 21 at the position shown by the dashed-dotted line in Fig. 1. In Fig. 1 to Fig. 9, a right-handed XYZ coordinated system is provided in which the direction (lateral direction as viewed from above in Fig. 1) of the arrangement of photoelectric conversion cells 10 is defined as the direction of the X-axis.

The photoelectric conversion device 21 comprises a structure in which a plurality of photoelectric conversion cells 10 are arranged on a substrate 1. Although only two photoelectric conversion cells 10 are shown in Fig. 1 for convenience of illustration, an actual photoelectric conversion device 21 is provided with a large number of photoelectric conversion cells 10 arranged planarly (two-dimensionally) in the lateral direction of the drawing and further in the vertical direction of the drawing perpendicular to the lateral direction.

Each photoelectric conversion cell 10 is principally provided with a lower electrode layer 2, a photoelectric conversion layer 3, an upper electrode layer 4, and a collecting electrode 5. In the photoelectric conversion device 21, the principal surface on the side on which the upper electrode layer 4 and the collecting electrode 5 are disposed is a light-receiving surface. Also, the photoelectric conversion device 21 is provided with three types of groove portions named as first to third groove portions P1, P2, and P3.

The substrate 1 is to support the plurality of photoelectric conversion cells 10 and materials, for example, glass, ceramics, resins, or metals may be adopted as the material of the substrate 1. Here, as the substrate 1, a blue plate glass (soda lime glass) having a thickness of about 1 to 3 mm is used.

The lower electrode layer 2 is a conductive layer disposed on one principal surface of the substrate 1 and metals, for example, molybdenum (Mo), aluminum (Al), titanium (Ti), tantalum (Ta), gold (Au) or the like, or laminate structures of these metals may be adopted as the material of the lower electrode layer 2. Also, the lower electrode layer 2 has a thickness of about 0.2 to 1 µm and, for example, is formed by a known thin-film forming method such as a sputtering method or a vapor deposition method.

The photoelectric conversion layer 3 has a structure in which a first semiconductor layer 31 as a light absorption layer and a second semiconductor layer 32 as a buffer layer are stacked.

The first semiconductor layer 31 is a semiconductor layer having a first conductivity type (here, a p-type conductivity type) and disposed on the +Z side principal surface (also called one principal surface) of the lower electrode layer 2 and has a thickness of about 1 to 3 µm. The first semiconductor layer 31 principally contains a Group I-III-VI compound semiconductor which is a chalcopyrite type (also called a CIS type) compound semiconductor from the viewpoint of improving conversion efficiency using small amounts of materials at low cost by decreasing the layer thickness. In this case, the description that a Group I-III-VI compound semiconductor is principally contained means that the Group I-III-VI compound semiconductor is contained in an amount of 70 mol% or more. Here, the first semiconductor layer 31 is designed to principally contain a chalcopyrite type Group I-III-VI compound semiconductor having a p-type conductivity type.

Here, the Group I-III-VI compound is a compound of a Group I-B element (in this specification, the name of the group is described by the old IUPAC system. In this case, the Group I-B element is also called a group 11 element under the new IUPAC system.), a Group III-B element (also called a group 13 element), and a Group VI-B element (also called a group 16 element). Then, examples of the Group I-III-VI compound include CuInSe₂ (copper indium diselenide, also called CIS), Cu(In, Ga)Se₂ (copper indium gallium diselenide, also called CIGS), and Cu(In, Ga)(Se, S)₂ (copper indium gallium di(selenide/sulfide), also called CIGSS). In this case, the first semiconductor layer 31 may be comprised of a thin film of a multinary compound semiconductor such as a copper indium gallium diselenide thin film provided with a surface layer of a copper indium gallium di(selenide/sulfide) thin film. Here, the light absorption layer 31 principally contains CIGS.

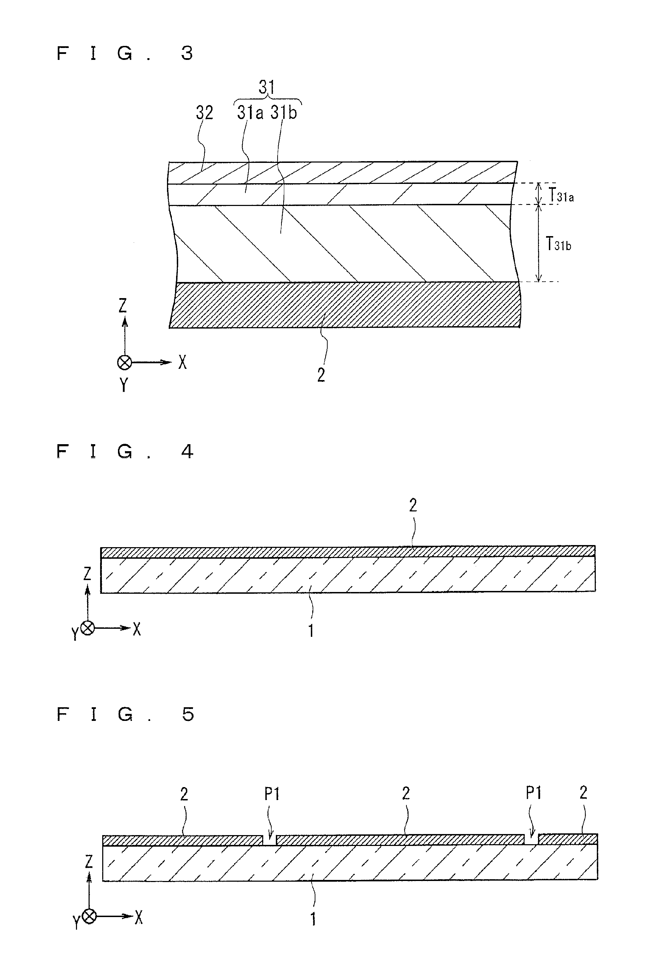

Fig. 3 is a schematic view showing a structure to give attention to the lower electrode layer 2, the first semiconductor layer 31, and the second semiconductor layer 32. The first semiconductor layer 31 is provided with a surface part 31a and a rest part 31 b.

The surface part 3 1 a constitutes a second semiconductor layer 32 side surface part of the first semiconductor layer 31. Also, the rest part 31b constitutes a part closer to the lower electrode layer 2 side than the surface part 31 a in the first semiconductor layer 31. Also, the ratio C_{VI}/C_{I} of the content C_{VI} of the Group VI-B element to the content C_{I} of the Group I-B element in the surface part 31a is larger than the ratio C_{VI}/C_{I} in the rest part 31b.

Such a structure reduces the loss of current at the junction part between the first semiconductor layer 31 and the second semiconductor layer 32 and also, improves the electrical connection between the first semiconductor layer 31 and the lower electrode layer 2, which improves photoelectric conversion efficiency.

It is to be noted that the surface part 31a means a thin layer region extending to a depth of 100 nm (corresponding to the thickness T₃₁ₐ of the surface part 31a in Fig. 3) from the second semiconductor layer 32 side surface of the first semiconductor layer 31. As the average value of the ratio C_{VI}/C_{I} in this region is designed to be larger than that in the rest part, the loss of current can be reduced effectively. The content of the Group I-B element and the Group VI-B element in the first semiconductor layer 31 may be found by measuring the section of the first semiconductor layer 31 by using any analysis method of XPS, XRD, SEM-EDS, and TEM-EDS. In this case, the thickness T_{31b} of the rest part 31b may be 5 to 50 times the thickness T₃₁ₐ of the surface part 31a from the viewpoint of improving the optical absorptance to thereby more improve photoelectric conversion efficiency.

For example, the ratio C_{VI}/C_{I} in the surface part 31a may be designed to be 1.1 times or more and 1.4 times or less the ratio C_{VI}/C_{I} in the rest part 31b. When the ratio C_{VI}/C_{I} is in the above range, a change in composition between the surface part 31a and the rest part 31b can be made to be a moderate level, so that a large change in physical properties can be suppressed to facilitate carrier movement.

The average value of the ratios C_{VI}/C_{I} in the surface part 31a may be designed to be 2.0 or more and 2.3 or less from the viewpoint of suppressing the production of a Group I-VI compound to decrease the loss of current in the surface part 31a. Also, the average value of the ratios C_{VI}/C_{I} in the rest part 31b may be designed to be 1.6 or more and 1.9 or less from the viewpoint of easily forming a Group I-VI compound (for example, Cu₂Se and/or CuSe) that has a relatively high conductivity in the rest part 31b to improve conductivity, thereby making easy the carrier movement to the lower electrode 2.

Also, the ratio C_{I}/C_{III} of the content C_{I} of the Group I-B element to the content C_{III} of the Group III-B element in the surface part 31a and the rest part 31b may be designed to be 0.8 or more from the viewpoint of suppressing the formation of a heterogeneous phase such as CuIn₃Se₅ in the first semiconductor layer 31 to improve photoelectric conversion efficiency. Also, the ratio C_{I}/C_{III} may be designed to be 1.1 or less from the viewpoint of suppressing excess production of a Group I-VI compound having a relatively high conductivity in the first semiconductor layer 31 to improve semiconductor characteristics.

The first semiconductor layer 31 as described above is formed by a process such as a so-called coating method or printing method. In the coating method, a semiconductor-forming solution containing elements constituting the first semiconductor layer 31 is applied to the lower electrode layer 2 and then, drying and heat treatment are carried out step by step.

The second semiconductor layer 32 is a semiconductor layer formed on one principal surface of the first semiconductor layer 31. This second semiconductor layer 32 has a conductive type (here, an n-type conductivity type) different from the conductivity type of the first semiconductor layer 31. Also, the second semiconductor layer 32 is disposed in the form of heterojunction with the first semiconductor layer 31. In the photoelectric conversion cell 10, photoelectric conversion occurs in the first semiconductor layer 31 and the second semiconductor layer 32 constituting the heterojunction and therefore, the first semiconductor layer 31 and the second semiconductor layer 32 are laminated on each other to function as the photoelectric conversion layer 3. In this case, a semiconductor differing in conductivity type means a semiconductor differing in the type of conductive carrier (carrier). Also, when the conductivity type of the first semiconductor layer 31 is a p-type as described above, the conductivity type of the second semiconductor layer 32 is not an n-type but may be an i-type. Moreover, an aspect is allowed in which the conductivity type of the first semiconductor layer 31 is an n-type or an i-type and the conductivity type of the second semiconductor layer 32 is a p-type.

The second semiconductor layer 32 mainly contains, for example, a compound semiconductor such as cadmium sulfide (CdS), indium sulfide (In₂S₃), zinc sulfide (ZnS), zinc oxide (ZnO), indium selenide (In₂Se₃), In(OH, S), (Zn, In), (Se, OH), or (Zn, Mg)O. Then, the second semiconductor layer 32 may have a resistivity of 1 Ω·cm or more from the viewpoint of reducing the loss of current. In this case, the second semiconductor layer 32 is formed in a thickness of, for example, 10 to 200 nm by, for example, a chemical bath deposition (CBD) method.

The upper electrode layer 4 is a transparent conductive film which is formed on the second semiconductor layer 32 and has an n-type conductivity type and is an electrode (also called an extraction electrode) that extracts charges produced at the photoelectric conversion layer 3. The upper electrode layer 4 mainly contains a substance having a lower resistivity than the second semiconductor layer 32. The upper electrode layer 4 includes a so-called window layer, and when a transparent conductive film is formed in addition to this window layer, these layers may be regarded as a united upper electrode layer 4.

The upper electrode layer 4 mainly contains a substance which has a wide forbidden band width, is transparent, and has low resistance, for example, a metal oxide semiconductor comprising of at least one of zinc oxide (ZnO), zinc oxide compound (those containing at least one element among Al, boron (B), gallium (Ga), indium (In), and fluorine (F)), indium oxide (ITO) containing tin (Sn) and tin oxide (SnO₂).

The upper electrode layer 4 is formed such that it has a thickness of 0.05 to 3.0 µm by a sputtering method, a vapor deposition method, a chemical vapor deposition (CVD) method, or the like. Here, the upper electrode layer 4 may be designed to have a resistivity less than 1 Ω·cm and a sheet resistance of 50 Ω/□ or less from the viewpoint of satisfactorily extracting charges from the photoelectric conversion layer 3.

The second semiconductor layer 32 and the upper electrode layer 4 each mainly contain a material having the nature (also called light permeability) that they easily transmit light having a wavelength range which can be absorbed by the first semiconductor layer 31. This structure suppresses, in the first semiconductor layer 31, the reduction in light absorption efficiency caused by the formation of the second semiconductor layer 32 and the upper electrode layer 4.

Also, the upper electrode layer 4 may be designed to have a thickness of 0.05 to 0.5 µm from the viewpoint of improving light permeability and also improving the effect of preventing the loss of light reflection and effect of scattering light at the same time, and further well transporting the current produced by photoelectric conversion. Moreover, the upper electrode layer 4 may have substantially the same absolute refractive index as that of the second semiconductor layer 32 from the viewpoint of preventing the loss of light reflection at the interface between the upper electrode layer 4 and the second semiconductor layer 32.

The collecting electrode 5 comprises a plurality of current collecting parts 5a disposed apart from each other in the direction of the Y-axis and each extending in the direction of the X-axis and a connecting part 5b connected with each current collecting part 5a and extending in the direction of the Y-axis. The collecting electrode 5 is an electrode having conductivity and principally contains metals such as silver (Ag).

The current collecting part 5a serves to collect the charges generated in the photoelectric conversion layer 3 and extracted in the upper electrode layer 4. If the current collecting part 5a is formed, the upper electrode layer 4 can be made thin.

The charges collected by the collecting electrode 5 and the upper electrode layer 4 are transported to the adjacent photoelectric conversion cell 10 through a connecting part 45 disposed in the second groove portion P2. The connecting part 45 is constituted of an extension part 4a of the upper electrode layer 4 and a trail part 5c formed on the extension part 4a and trailing from the connecting part 5b. This ensures that, in this photoelectric conversion device 21, the lower electrode layer 2 of one of the neighboring photoelectric conversion cells 10 is electrically connected in series with the upper electrode layer 4 and the collecting electrode 5 of the other photoelectric conversion cell 10 through the connecting part 45 provided in the second groove portion P2 and used as a connecting conductor.

The collecting electrode 5 may be designed to have a width of 50 to 400 µm so as to limit, to a minimum, the reduction of the light-receiving area having an influence on the quantity of incident light to the light absorption layer 31 while securing good conductivity.

### <(2) Method of manufacturing a photoelectric conversion device>

Fig. 4 to Fig. 9 are each a sectional view schematically showing a state of a photoelectric conversion device 21 during the course of manufacture. Each sectional view shown in Fig. 4 to Fig. 9 shows the state of the part corresponding to the section shown in Fig. 2 during the course of manufacture.

First, as shown in Fig. 4, a lower electrode layer 2 comprised of Mo or the like is formed on the almost entire surface of a washed substrate 1 by using a sputtering method. Then, a first groove portion P1 is formed which extends from a linear forming target position along the Y direction among the upper surface of the lower electrode layer 2 to the upper surface of the substrate 1 positioned just below the above-mentioned position. The first groove P1 can be formed by, for example, the scribe processing performed by groove-processing in which the forming target position is irradiated with laser light from a YAG laser or the like with scanning the laser light. Fig. 5 is a drawing showing a state after the first groove portion P1 is formed.

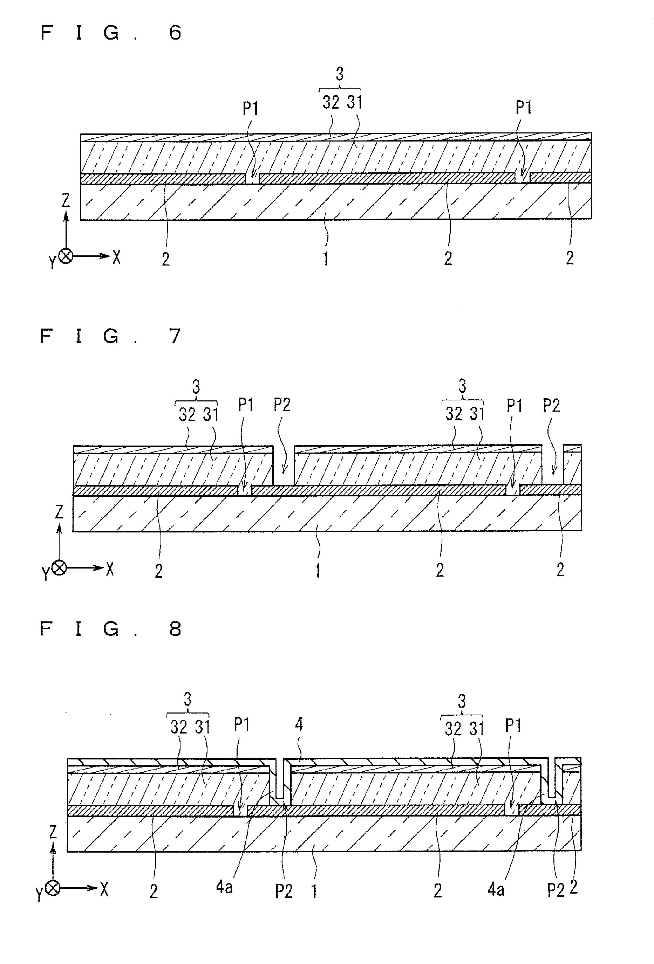

After the first groove portion P 1 is formed, a first semiconductor layer 31 and a second semiconductor layer 32 are formed step by step on the lower electrode layer 2. Fig. 6 is a drawing showing a state after the first semiconductor layer 31 and the second semiconductor layer 32 are formed.

When the first semiconductor layer 31 is formed, a semiconductor-forming solution used to form the first semiconductor layer 31 is first prepared. The semiconductor-forming solution is prepared by dissolving or dispersing the Group I-B element, Group III-B element, and Group VI-B element (hereinafter these elements used as the raw materials are also called raw material elements) which serve as the raw materials for forming a Group I-III-VI compound semiconductor in a solvent. The raw material element is contained in the semiconductor-forming solution in the state of a single element, a compound such as a complex or a salt, or single microparticles or compound microparticles. A solution obtained by dissolving a single source precursor (see the specification of U.S. Patent No. 6992202), in which the Group I-B element, Group III-B element, and Group VI-B element constituting the Group I-III-VI compound semiconductor are included in one molecule, in a solvent is used for a semiconductor-forming solution from the viewpoint that film formation is well achieved by application and formation of crystals is well achieved. Also, various types of organic solvents or water are used as the solvent for the semiconductor-forming solution.

In this case, there is the case where the semiconductor-forming solution does not contain a Group VI-B element. In this case, it is sufficient that a Group VI-B element is contained in the atmosphere when the film formed using the semiconductor-forming solution is heat-treated.

The first semiconductor layer 31 is formed by applying the semiconductor-forming solution prepared in the above manner to one principal surface of the lower electrode layer 2 and drying the solution to form a film (hereinafter also called a precursor layer) as a precursor, followed by heat-treating the precursor layer. The semiconductor-forming solution is applied by using, for example, a spin coater, screen printing, dipping, spraying, a die coater or the like.

The drying for forming the precursor layer is performed in an inert atmosphere or a reduction atmosphere and the drying temperature may be, for example, 50 to 300°C. As this inert atmosphere, for example, a nitrogen atmosphere is given as an example. As the reduction atmosphere, for example, a forming gas atmosphere, a hydrogen atmosphere and the like can be mentioned. At the time of drying, heat decomposition of organic components may also be performed.

With regard to a method (first method) of forming the surface part 31a and the rest part 31b differing in the ratio of contents of the Group I-B element and the Group VI-B element, semiconductor-forming solutions differing in the ratio of contents of the Group I-B element and the Group VI-B element are laminated one by one to thereby form a precursor layer as a laminate with members differing in the ratio of contents of the Group I-B element and the Group VI-B element. The precursor layer formed in this manner is heat-treated to, for example, a maximum temperature of 500 to 600°C at a temperature rise rate of, for example, 5 to 30°C/min to form the first semiconductor layer 31 provided with the surface part 31a and the rest part 31b. The heat treatment of the precursor layer is performed under an inert atmosphere or a reduction atmosphere. The atmosphere for heat treatment may involve a chalcogen element (that means S, Se, and Te among Group VI-B elements) as a Group VI-B element constituting the Group I-III-VI compound semiconductor.

Or, in another method (second method) of forming the surface part 31 a and the rest part 31 b differing in the ratio of contents of the Group I-B element and the Group VI-B element, a precursor layer as a laminate with members differing in a ratio of content of the Group III-B element to content of the Group I-B element is formed. The precursor layer formed in this manner is heat-treated in an atmosphere involving a chalcogen element as a Group VI-B element constituting the Group I-III-VI compound semiconductor to thereby form a first semiconductor layer 31 including the surface part 3 1 a and the rest part 31 b.

Or, in a further method (third method) of forming the surface part 31a and the rest part 31 b differing in the ratio of contents of the Group I-B element and the Group VI-B element, the surface part 31a and the rest part 31 b are formed by utilizing the phenomenon that the Group I-B element is transported to the lower electrode layer 2 side when the precursor layer is heat-treated. In such a method utilizing the phenomenon of the transportation of the Group I-B element, the precursor layer is first kept at a relatively low temperature range of 100°C or more and 400°C or less for a predetermined time. The raw material elements constituting the precursor layer are thereby melted and liquefied, and at this time, the Group I-B element having a relatively low solubility than other elements (Group III-B element and Group IV-B element) tends to move to the lower electrode layer 2 side. As a result, the surface part 31a and the rest part 31b are formed. In this case, as the heat-treating atmosphere, an inert atmosphere, a reduction atmosphere, or a chalcogen element-containing atmosphere is used.

The second semiconductor layer 32 is formed by the solution growth method (also called a CBD method). For example, cadmium acetate and thiourea are dissolved in aqueous ammonia and the substrate 1 processed up to the formation of the first semiconductor layer 31 is dipped in the resulting solution to thereby form the second semiconductor layer 32 comprised of CdS on the first semiconductor layer 31.

After the first semiconductor layer 31 and the second semiconductor layer 32 are formed, a second groove portion P2 is formed which extends from a linear forming target position along the Y direction among the upper surface of the second semiconductor layer 32 to the upper surface of the lower electrode layer 2 positioned just below the above-mentioned position. The second groove portion P2 is formed by, for example, performing scribing using a scribing needle having a scribe width of about 40 to 50 µm continuously several times with shifting the pitch. Also, the second groove portion P2 may be formed by performing scribing in the state that the width of the tip of the scribing needle is increased to a level close to the width of the second groove portion P2. Or, two or more scribing needles may be fixed in the state that they are disposed in contact with each other or close to each other and one or several scribing treatments may be performed to form the second groove portion P2. Fig. 7 is a drawing showing a state after the second groove portion P2 is formed. The second groove portion P2 is formed at a position slightly shifted in the direction of X (direction of +X in the drawing) from the position of the first groove portion P1.

After the second groove portion P2 is formed, a transparent upper electrode layer 4 containing, for example, indium oxide (ITO) containing Sn or the like as a major component is formed on the second semiconductor layer 32. The upper electrode layer 4 is formed by, for example, a sputtering method, a vapor deposition method, or a CVD method. Fig. 8 is a drawing showing a state after the upper electrode layer 4 is formed.

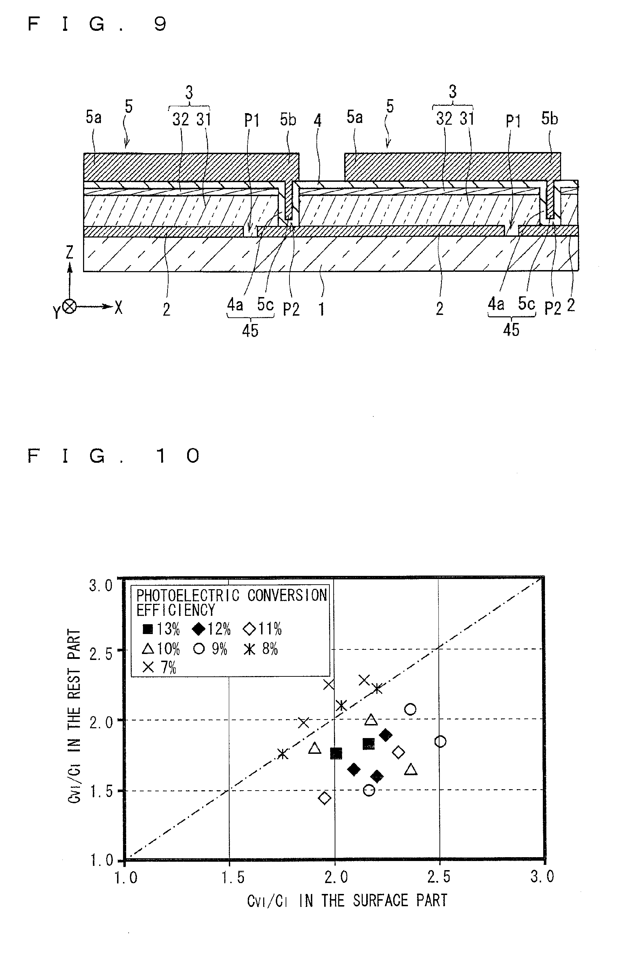

After the upper electrode layer 4 is formed, the collecting electrode 5 is formed. With regard to the collecting electrode 5, a paste having conductivity (also called a conductive paste) in which, for example, a metal powder of Ag or the like is dispersed in a resin binder or the like is printed so as to draw a desired pattern and dried to solidify to thereby form the collecting electrode 5. The solidified state includes both a solidified state after a binder resin is melted in the case where the binder to be used in the conducting paste is a thermoplastic resin, and a solidified state after the resin is cured in the case where the binder is a curable resin such as a thermosetting resin or a photocurable resin. Fig. 9 is a drawing showing a state after the collecting electrode 5 is formed.

After the collecting electrode 5 is formed, a third groove portion P3 is formed which extends from a linear forming target position among the upper surface of the upper electrode layer 4 to the upper surface of the lower electrode layer 2 positioned just below the above-mentioned position. The width of the third groove portion P3 is preferably, for example, about 40 to 1000 µm. Also, like the second groove portion P2, the third groove portion P3 is preferably formed by mechanical scribing. In this manner, the photoelectric conversion device 21 shown in Fig. 1 and Fig. 2 is formed by the formation of the third groove portion P3.

### <(3) Other modified example of the photoelectric conversion device (second example)>

It is to be noted that the present invention is not limited to the above embodiment and can be variously changed or improved without departing from the spirit of the present invention.

For example, in the above photoelectric conversion device 21, the first semiconductor layer 31 may have voids and the porosity of the rest part 31b may be larger than the porosity (including the surface part 31a having no void) of the surface part 31a. If the first semiconductor layer 31 has such a structure, when thermal stress is applied to the photoelectric conversion device 21, the voids effectively relax the stress, which enables effective reduction in the occurrence of cracks or the like in the first semiconductor layer 31. Then, when such voids are formed such that the porosity of the surface part 31a is smaller than that of the rest part 31b, electrical junction between the surface part 31a and the second semiconductor layer 32 is improved. On the other hand, the conductivity between the rest part 31b and the lower electrode layer 2 is improved since the content ratio C_{VI}/C_{I} of the rest part 31b is smaller than that of the surface part as mentioned above and therefore, the electrical connection between the rest part 31 band the lower electrode layer 2 can be well maintained even if the porosity of the rest part 31b is designed to be higher than that of the surface part 31a.

In this case, the porosity can be found by measuring the ratio of the area occupied by voids in the first semiconductor layer 31 from a SEM image obtained by SEM observation of a section of the first semiconductor layer 31. The porosity of the surface part 31a may be 0 to 5% from the viewpoint of improving the electrical junction between the surface part 31a and the second semiconductor layer 32. The porosity of the rest part 31b may be 6 to 50% from the viewpoint of improving the relaxation of stress.

The first semiconductor layer 31 having porosities differing in the direction of the thickness can be manufactured in the following manner. For example, when the first semiconductor layer 31 is produced to have a laminate structure with a plurality of layers and heat treatment is carried out at a relatively high temperature rise rate in the production of a layer on the lower electrode layer 2 side of the laminate structure, voids are easily produced. Next, when heat treatment is carried out at a relatively low temperature rise rate in the production of a layer on the second semiconductor layer 32 side, the layer tends to be dense.

### <(4) Other modified example of the photoelectric conversion device (third example) >

In the above photoelectric conversion device 21, the first semiconductor layer 31 may be comprised of a plurality of crystal particles bonded with each other, wherein the average particle diameter of these crystal particles in the rest part 31b may be smaller than the average particle diameter of crystal particles in the surface part 31a. Such a structure ensures that the recombination of the carriers produced by photoelectric conversion can be reduced by relatively increasing the average particle diameter of crystal particles in the surface part 31a and also, thermal stress can be relaxed, enabling effective reduction of generation of cracks and the like in the first semiconductor layer 31 by relatively reducing the average particle diameter of crystal particles in the rest part 31 b. Here, the rest part 31b is improved in conductivity since the content ratio C_{VI}/C_{I} of the rest part 31b is smaller than that of the surface part as mentioned above and therefore, electrical connection can be satisfactorily maintained even if there are many grain boundaries among crystal particles.

In this case, the average particle diameter of crystal particles in the first semiconductor layer 31 is obtained by regarding the maximum diameter of each crystal particle as a particle diameter in a SEM image obtained by SEM observation of a section of the first semiconductor layer 31 and calculating an average of these particle diameters. The average particle diameter of crystal particles in the surface part 31 a may be 600 to 1000 nm from the viewpoint of improving the electrical junction between the surface part 31a and the second semiconductor layer 32. On the other hand, the average particle diameter of crystal particles in the rest part 31b may be 30 to 500 nm from the viewpoint of improving the stress relaxation.

The first semiconductor layer 31 having a different average particle diameter in the direction of the thickness like this can be manufactured in the following manner. For example, when the first semiconductor layer 31 is positively heated by an IR lamp or the like from the surface on the second semiconductor layer 32 side in the production of the first semiconductor layer 31, crystallization of the surface part is promoted to thereby make increase of particle diameter easy.

### <(5) Other modified examples of the photoelectric conversion device>

Although the precursor layer which is to be the first semiconductor layer 31 is formed from the semiconductor layer-forming solution in the above embodiment, the present invention is not limited to this. For example, it is also possible to employ an aspect in which the precursor layer is formed by a thin-film forming method such as sputtering or vapor deposition.

Although the structure adopting CIGS as the Group I-III-VI compound constituting the light absorption layer 31 is mainly explained in the above embodiment, the present invention is not limited to this. For example, even in the case where the Group I-III-VI compound has other compositions such as CIS and CIGSS, the conversion efficiency of the photoelectric conversion device is improved.

It is needless to say that all or a part of the structures each constituting the above embodiment and modified examples can be optionally combined insofar as they are consistent with each other.

### Examples

Then, the photoelectric conversion device 21 will be explained by way of specific examples.

Here, first, the following steps [a] to [d] were carried out sequentially to produce a semiconductor-forming solution.

[a] 10 mmol of Cu(CH₃CN)₄·PF₆ which is an organometallic complex of a Group I-B element and 20 mmol of P(C₆H₅)₃ which is a Lewis basic organic compound were dissolved in 100 ml of acetonitrile and then, the mixture was stirred at ambient temperature (for example, about 25°C) for 5 hours to prepare a first complex solution.

[b] 40 mmol of sodium methoxide (NaOCH₃) which is a metal alkoxide and 40 mmol of HSeC₆H₅ which is a chalcogen element-containing organic compound were dissolved in 300 ml of methanol, and further, 6 mmol of InCl₃ and 4 mmol of GaCl₃ were dissolved in the solution, followed by stirring at ambient temperature for 5 hours to prepare a second complex solution.

[c] The second complex solution prepared in the step [b] was added dropwise at a rate of 10 ml/min to the first complex solution prepared in the step [a] to produce a white precipitate (sediment). After the above dropping treatment was finished, stirring at ambient temperature for 1 hour and extraction of the precipitate by using a centrifuge were performed sequentially. In the extraction of the sediment, a process of dispersing the sediment separated once by the centrifuge in 500 ml of methanol and then, again separating the sediment by a centrifuge was repeated twice. Finally, this sediment was dried at ambient temperature to thereby obtain a sediment containing a single source precursor. In this single source precursor, Cu, In, and Se are contained or Cu, Ga, and Se are contained in one complex molecule.

[d] Pyridine which is an organic solvent was added to the sediment obtained in the step [c] and containing a single source precursor to thereby produce a solution in which the concentration of the single source precursor was 45% by mass. After that, phenylselenol (C₆H₅SeH) was added to the solution in various amounts based on the total amount of the single source precursor and each mixture was stirred at 80°C for 60 minutes to dissolve the powder in the solution, thereby producing various semiconductor-forming solutions differing in the ratio of contents of the raw material elements.

Then, a material obtained by forming a lower electrode layer comprised of Mo or the like on a surface of a substrate comprised of glass was prepared and the semiconductor-forming solution was applied on the lower electrode layer by a blade method, followed by drying at 300°C for 10 minutes to form a film (precursor layer). The precursor layer was formed by performing treatments including application using the blade method and subsequent drying ten times. At this time, various solutions differing in the ratio of contents of the raw material elements were used as the semiconductor layer-forming solutions used for the application of each layer, so that the lower region which was to be the rest part was different from the surface region which was to be the surface part in the ratio of contents of the raw material elements.

After that, the precursor layer was heat-treated in an atmosphere of a mixed gas of hydrogen gas and selenium steam gas. In this heat treatment, the temperature was raised to 550°C from a temperature close to ambient temperature in 5 minutes and the precursor layer was kept at 550°C for 2 hours to form a first semiconductor layer having a thickness of 2 µm and mainly comprised of CIGS. In this first semiconductor layer, a region having a thickness of 100 nm from the surface opposite to the lower electrode layer was defined as a surface part and a region closer to the lower electrode layer side than the surface part of the first semiconductor layer was defined as a rest part, and the section of each region was analyzed by XPS analysis. The results are shown in Fig. 10. In this case, there was almost no difference between the surface part and the rest part in the ratio C_{I}/C_{III} of the content C_{I} of the Group I-B element to the content C_{III} of the Group III-B element and the ratio C_{I}/C_{III} was almost constant (0.9) in the entire first semiconductor layer.

Moreover, each substrate processed up to the formation of the first semiconductor layer was dipped in a solution prepared by dissolving zinc acetate and thiourea in aqueous ammonia to form a 50-nm-thick second semiconductor layer comprised of ZnS on the first semiconductor layer. Then, a transparent conductive film comprised of ZnO doped with Al was formed on the second semiconductor layer by a sputtering method and finally, an extraction electrode comprised of Al was formed by vapor deposition to manufacture each photoelectric conversion device.

The conversion efficiency of each photoelectric conversion device manufactured in this manner was measured. With regard to the conversion efficiency, it was measured using a so-called fixed light solar simulator under the state that the intensity of light applied to the light-receiving surface of the photoelectric conversion device was 100 mW/cm² and AM (air mass) was 1.5. The results are shown in Fig. 10.

It was found from Fig. 10 that the conversion efficiency was high when the ratio C_{VI}/C_{I} of the content C_{VI} of the Group VI-B element to the content C_{I} of the Group I-B element in the surface part was larger than the ratio C_{VI}/C_{I} in the rest part. It was found that the conversion efficiency was higher particularly when the average value of the ratio C_{VI}/C_{I} in the surface part was 2.0 or more and 2.3 or less and the average value of the ratio C_{VI}/C_{I} in the rest part was 1.6 or more and 1.9 or less.

### Reference Signs List

- 1: Substrate
- 2: Lower electrode layer
- 3: Photoelectric conversion layer
- 4: Upper electrode layer
- 5: Collecting electrode
- 10: Photoelectric conversion cell
- 21: Photoelectric conversion device
- 31: First semiconductor layer
- 31a: Surface part
- 31b: Rest part
- 32: Second semiconductor layer
- 45: Connecting part

## Claims

1. A photoelectric conversion device comprising:
an electrode;
a first semiconductor layer containing a Group I-III-VI compound semiconductor and formed on the electrode; and
a second semiconductor layer having a conductivity type different from that of the first semiconductor layer and formed on the first semiconductor layer, wherein;
the first semiconductor layer is **characterized in that** a ratio C_{VI}/C_{I} of the content C_{VI} of a Group VI-B element to the content C_{I} of a Group I-B element in a surface part of the second semiconductor layer side thereof is larger than the ratio C_{VI}/C_{I} in a rest part thereof.

2. The photoelectric conversion device according to claim 1, wherein a ratio C_{I}/C_{III} of the content C_{I} of a Group I-B element to the content C_{III} of a Group III-B element in each of the surface part and the rest part is 0.8 or more and 1.1 or less.

3. The photoelectric conversion device according to claim 1 or 2, wherein the average value of the ratio C_{VI}/C_{I} in the surface part is 2.0 or more and 2.3 or less and the average value of the ratio C_{VI}/C_{I} in the rest part is 1.6 or more and 1.9 or less.

4. The photoelectric conversion device according to any one of claims 1 to 3, wherein the Group I-B element is Cu and the Group VI-B element is Se.

5. The photoelectric conversion device according to any one of claims 1 to 4, wherein the first semiconductor layer comprises a void and the porosity of the rest part is larger than the porosity of the surface part.

6. The photoelectric conversion device according to any one of claims 1 to 5, wherein the first semiconductor layer is obtained by bonding a plurality of crystal particles and the average particle diameter of the crystal particles in the rest part is smaller than the average particle diameter of the crystal particles in the surface part.
